Europäisches Patentamt

European Patent Office

Office européen des brevets

(19)

(11) **EP 1 314 254 B1**

(12) **EUROPEAN PATENT SPECIFICATION**

(45) Date of publication and mention
of the grant of the patent:
**14.06.2006 Bulletin 2006/24**

(51) Int Cl.:
***H03M 13/29*** (2006.01)    ***H04L 27/06*** (2006.01)

(21) Application number: **01926783.0**

(22) Date of filing: **10.04.2001**

(86) International application number:
**PCT/US2001/011544**

(87) International publication number:
**WO 2001/082486 (01.11.2001 Gazette 2001/44)**

(54) **ITERATION TERMINATING FOR TURBO DECODER**

ITERATIONSABBRUCH Für Turbodecodierer

INTERRUPTION  D'ITERATION POUR  TURBODECODEUR

(84) Designated Contracting States:
**AT BE CH CY DE DK ES FI FR GB GR IE IT LI LU
MC NL PT SE TR**

(30) Priority: **20.04.2000   US 553646**

(43) Date of publication of application:
**28.05.2003   Bulletin 2003/22**

(73) Proprietor: **MOTOROLA, INC.**
**Schaumburg, IL 60196 (US)**

(72) Inventors:
  • **Xu, Shuzham J.**
    **Edison, NJ 08817 (US)**
  • **Teicher, Haim**
    **Manalapan, NJ 07726 (US)**

(74) Representative: **Cross, Rupert Edward Blount et al**
**Boult Wade Tennant**
**Verulam Gardens**
**70 Gray's Inn Road**
**London WC1X 8BT (GB)**

(56) References cited:
**US-A- 5 761 248**

• **HAGENAUER J ET AL: "ITERATIVE DECODING
OF BINARY BLOCK AND CONVOLUTIONAL
CODES" IEEE TRANSACTIONS ON
INFORMATION THEORY, IEEE INC. NEW YORK,
US, vol. 42, no. 2, March 1996 (1996-03), pages
429-445, XP000850507 ISSN: 0018-9448**

• **BAUCH G ET AL: "ITERATIVE EQUALIZATION
AND DECODING IN MOBILE COMMUNICATIONS
SYSTEMS" PROCEEDINGS OF EUROPEAN
PERSONAL AND MOBILE COMMUNICATIONS
CONFERENCE, XX, XX, 30 September 1997
(1997-09-30), pages 307-312, XP002060630**

• **ZHAI F ET AL: "New Error Detection Techniques
and Stopping Criteria for Turbo Decoding"
CANADIAN CONFERENCE ON ELECTRICAL
AND COMPUTER ENGINEERING, XX, XX, vol. 1,
7 March 2000 (2000-03-07), pages 58-62,
XP002242678**

• **CHANG Y: "Q-ary Turbo Codes with QAM
Modulations" INTERNATIONAL CONFERENCE
ON UNIVERSAL PERSONAL
COMMUNICATIONS, IEEE, NEW YORK, NY, US,
vol. 2, 29 September 1996 (1996-09-29), pages
814-817, XP002135988**

• **SHAO R Y ET AL: "Two simple stopping criteria
for iterative decoding" INFORMATION THEORY,
1998. PROCEEDINGS. 1998 IEEE
INTERNATIONAL SYMPOSIUM ON CAMBRIDGE,
MA, USA 16-21 AUG. 1998, NEW YORK, NY, USA,
IEEE, US, 16 August 1998 (1998-08-16), page 279
XP010297151 ISBN: 0-7803-5000-6**

• **ROBERTSON P: "ILLUMINATING THE
STRUCTURE OF CODE AND DECODER OF
PARALLEL" PROCEEDINGS OF THE GLOBAL
TELECOMMUNICATIONS CONFERENCE
(GLOBECOM). SAN FRANCISCO, NOV. 28 - DEC.
2, 1994, NEW YORK, IEEE, US, vol. 3, 28
November 1994 (1994-11-28), pages 1298-1303,
XP000488744 ISBN: 0-7803-1821-8**

• **WANG ET AL.: 'Iterative (Turbo) soft interference
cancellation and decoding for coded CDMA' IEEE
vol. 47, no. 7, July 1999, pages 1046 - 1061,
XP002943933**

EP 1 314 254 B1

- CHIU, MAO-CHING: 'Decision feedback soft-imput-output multiuser detector for iterative decoding of coded CDMA' IEEE vol. 50, no. 1, January 2001, pages 25 - 33, XP002943934

- OGIWARA ET AL.: 'Iterative decoding of serially concatenated punctured trellis-coded modulation' IEICE TRANS. vol. E82-A, no. 10, October 1999, pages 2089 - 2095, XP002943935

**Description**

FIELD OF THE INVENTION

This invention relates generally to communication systems, and more particularly to a decoder for use in a receiver of a convolutionally coded communication system.

BACKGROUND OF THE INVENTION

Convolutional codes are often used in digital communication systems to protect transmitted information from error. Such communication systems include the Direct Sequence Code Division Multiple Access (DS-CDMA) standard IS-95 and the Global System for Mobile Communications (GSM). Typically in these systems, a signal is convolutionally coded into an outgoing code vector that is transmitted. At a receiver, a practical soft-decision decoder, such as a Viterbi decoder as is known in the art, uses a trellis structure to perform an optimum search for the maximum likelihood transmitted code vector.

More recently, turbo codes have been developed that outperform conventional coding techniques. Turbo codes are generally composed of two or more convolutional codes and turbo interleavers. Turbo decoding is iterative and uses a soft output decoder to decode the individual convolutional codes. The soft output decoder provides information on each bit position which helps the soft output decoder decode the other convolutional codes. The soft output decoder is usually a MAP (maximum *a posteriori)* or soft output Viterbi algorithm (SOVA) decoder.

Turbo coding is efficiently utilized to correct errors in the case of communicating over an added white Gaussian noise (AWGN) channel. Intuitively, there are a few ways to examine and evaluate the error correcting performance of the turbo decoder. One observation is that the magnitude of log-likelihood ratio (LLR) for each information bit in the iterative portion of the decoder increases as iterations go on. This improves the probability of the correct decisions. The LLR magnitude increase is directly related to the number of iterations in the turbo decoding process. However, it is desirable to reduce the number of iterations to save calculation time and circuit power. The appropriate number of iterations (stopping criteria) for a reliably turbo decoded block varies as the quality of the incoming signal and the resulting number of errors incurred therein. In other words, the number of iterations needed is related to channel conditions, where a more noisy environment will need more iterations to correctly resolve the information bits and reduce error.

One prior art stopping criteria utilizes a parity check as an indicator to stop the decoding process. A parity check is straightforward as far as implementation is concerned. However, a parity check is not reliable if there are a large number of bit errors. Another type of criteria for the turbo decoding iteration stop is the LLR (log-likelihood-ratio) value as calculated for each decoded bit. Since turbo decoding converges after a number of iterations, the LLR of a data bit is the most direct indicator index for this convergence. One way this stopping criteria is applied is to compare LLR magnitude to a certain threshold. However, it can be difficult to determine the proper threshold as channel conditions are variable. Still other prior art stopping criteria measure the entropy or difference of two probability distributions, but this requires much calculation. A publication disclosing such stopping criteria is disclosed in the article *Iterative Decoding of Binary Block and Convolutional Codes* by Hagenauer, J; Offer E.; Pabke L., IEEE Transactions on Information Theory, March 1996, IEEE, USA, ISSN 0018-9448, Vol. 48, nr. 2, pp 429-445.

There is a need for a decoder that can determine the appropriate stopping point for the number of iterations of the decoder in a reliable manner. It would also be of benefit to provide the stopping criteria without a significant increase in calculation complexity.

BRIEF DESCRIPTION OF THE DRAWINGS

FIG. 1 shows a trellis diagram used in soft output decoder techniques as are known in the prior art;
FIG. 2 shows a simplified block diagram for turbo encoding as is known in the prior art;
FIG. 3 shows a simplified block diagram for a turbo decoder as is known in the prior art;
FIG. 4 shows a simplified block diagram for a turbo decoder with an iterative quality index criteria, in accordance with the present invention;
FIG. 5 shows simplified block diagram for the Viterbi decoder as used in FIG. 4;
FIG. 6 shows a graphical representation of the improvement provided by the hard quality index of the present invention;
FIG. 7 shows a graphical representation of the improvement provided by the soft quality index of the present invention;
FIG. 8 shows another graphical representation of the improvement provided by the present invention;
FIG. 9 shows a graphical representation of the improvement provided by the hard intrinsic SNR index of the present invention;

FIG. 10 shows a graphical representation of the improvement provided by the soft intrinsic SNR index of the present invention; and

FIG. 11 shows a method for turbo decoding, in accordance with the present invention.

DETAILED DESCRIPTION OF THE PREFERRED EMBODIMENT

The present invention provides a turbo decoder that dynamically utilizes the virtual (intrinsic) SNR as a quality index stopping criteria of the in-loop data stream at the input of each consutituent decoder stage, as the loop decoding iterations proceed. This quality index is used as a stopping criteria to determine the number of iterations needed in the decoder. Advantageously, by limiting the number of calculations to be performed in order to decode bits reliably, the present invention conserves power in the communication device and saves calculation complexity.

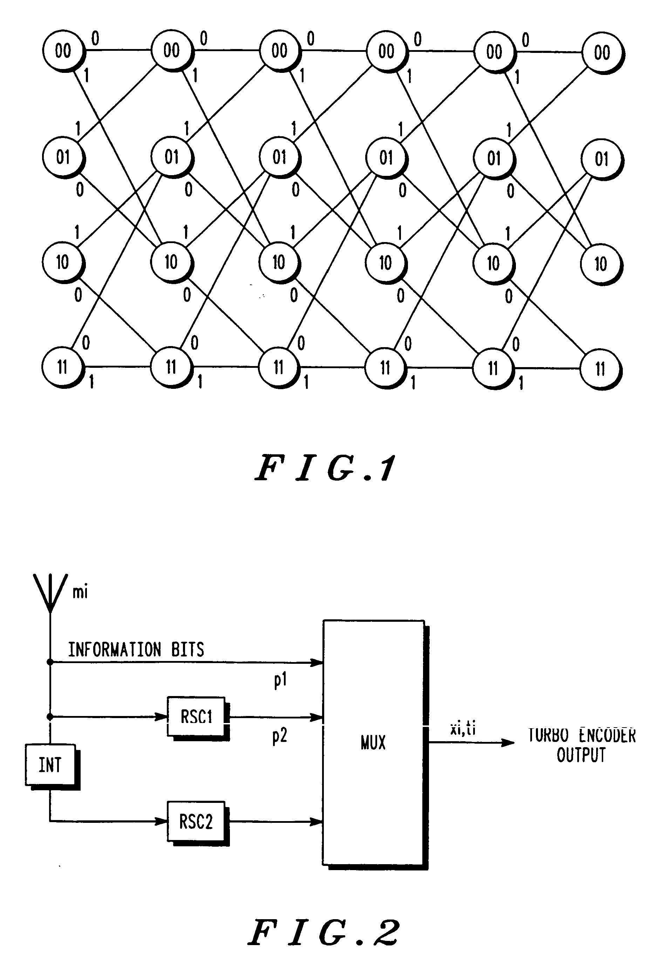

Typically, block codes, convolutional codes, turbo codes, and others are graphically represented as a trellis as shown in FIG. 1, wherein a four state, five section trellis is shown. For convenience, we will reference $M$ states per trellis section (typically $M$ equals eight states) and $N$ trellis sections per block or frame (typically $N$=5000). Maximum *a posteriori* type decoders (log-MAP, MAP, max-log-MAP, constant-log-MAP, etc.) utilize forward and backward generalized Viterbi recursions or soft output Viterbi algorithms (SOVA) on the trellis in order to provide soft outputs at each section, as is known in the art. The MAP decoder minimizes the decoded bit error probability for each information bit based on all received bits.

Because of the Markov nature of the encoded sequence (wherein previous states cannot affect future states or future output branches), the MAP bit probability can be broken into the past (beginning of trellis to the present state), the present state (branch metric for the current value), and the future (end of trellis to current value). More specifically, the MAP decoder performs forward and backward recursions up to a present state wherein the past and future probabilities are used along with the present branch metric to generate an output decision. The principles of providing hard and soft output decisions are known in the art, and several variations of the above described decoding methods exist. Most of the soft input-soft output (SISO) decoders considered for turbo codes are based on the prior art optimal MAP algorithm in a paper by L.R. Bahl, J. Cocke, F. Jelinek, and J. Raviv entitled "Optimal Decoding of Linear Codes for Minimizing Symbol Error Rate", IEEE Transactions on Information Theory, Vol. IT-20, March 1974, pp. 284-7 (BCJR algorithm).

FIG. 2 shows a typical turbo coder that is constructed with interleavers and constituent codes which are usually systematic convolutional codes, but can be block codes also. In general, a turbo encoder is a parallel concatenation of two recursive systemic convolutional encoders (RSC) with an interleaver (int) between them. The output of the turbo encoding is generated by multiplexing (concatenating) the information bits $m_i$ and the parity bits $p_i$ from the two encoders, RSC1 and RSC2. Optionally, the parity bits can be punctured as is known in the art to increase code rate (i.e., a throughput of 1/2). The turbo encoded signal is then transmitted over a channel. Noise, $n_i$, due to the AWGN nature of the channel becomes added to the signal, $x_i$, during transmission. The noise variance of the AWGN can be expressed as $\sigma^2 = N_o/2$, where $N_o/2$ is the two sided noise power spectrum density. The noise increases the likelihood of bit errors when a receiver attempts to decode the input signal, $y_i (= x_i + n_i)$, to obtain the original information bits $m_i$. Correspondingly, noise affects the transmitted parity bits to provide a signal $t_i = p_i + n_i$.

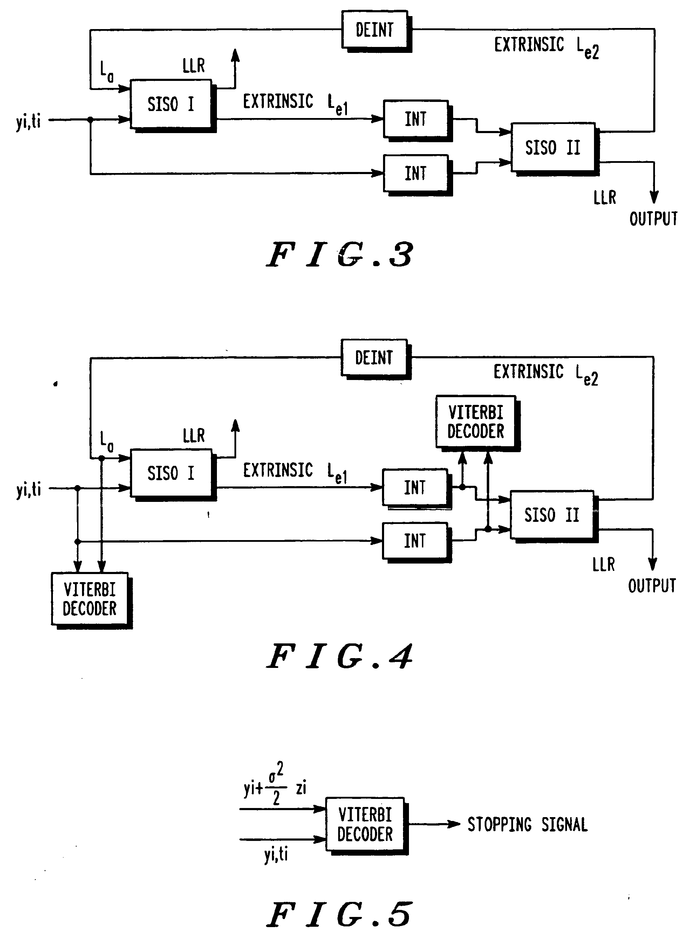

FIG. 3 shows a typical turbo decoder that is constructed with interleavers, de-interleavers, and decoders. The mechanism of the turbo decoder regarding extrinsic information $L_{e1}$, $L_{e2}$, interleaver (int), de-interleaver (deint), and the iteration process between the soft-input, soft-output decoder sections SISO1 and SISO2 follow the Bahl algorithm. Assuming zero decoder delay in the turbo decoder, the first decoder (SISO1) computes a soft output from the input signal bits, $y_i$, and the a priori information ($L_a$), which will be described below. The soft output is denoted as $L_{e1}$, for extrinsic data from the first decoder. The second decoder (SISO2) is input with interleaved versions of $L_{e1}$ (the a priori information from $L_a$), the input signal bits $y_i$. The second decoder generates extrinsic data, $L_{e2}$, which is deinterleaved to produce $L_a$ which is fed back to the first decoder, and a soft output (typically a MAP LLR) provide a soft output of the original information bits $m_i$. Typically, the above iterations are repeated for a fixed number of times (usually sixteen) for each bit until all the input bits are decoded.

MAP algorithms minimize the probability of error for an information bit given the received sequence, and they also provide the probability that the information bit is either a 1 or 0 given the received sequence. The prior art BCJR algorithm provides a soft output decision for each bit position (trellis section of FIG. 1) wherein the influence of the soft inputs within the block is broken into contributions from the past (earlier soft inputs), the present soft input, and the future (later soft inputs). The BCJR decoder algorithm uses a forward and a backward generalized Viterbi recursion on the trellis to arrive at an optimal soft output for each trellis section (stage). These *a posteriori* probabilities, or more commonly the log-likelihood ratio (LLR) of the probabilities, are passed between SISO decoding steps in iterative turbo decoding. The LLR for each information bit is

$$\qquad\qquad\qquad\qquad\qquad\qquad (1)$$

for all bits in the decoded sequence ($k$ = 1 to $\overline{N}$). In equation (1), the probability that the decoded bit is equal to 1 (or 0) in the trellis given the received sequence is composed of a product of terms due to the Markov property of the code. The Markov property states that the past and the future are independent given the present. The present, $\gamma_k(n,m)$, is the probability of being in state m at time k and generating the symbol $\gamma_k$ when the previous state at time $k$-1 was $n$. The present plays the function of a branch metric. The past, $\alpha_t(m)$, is the probability of being in state m at time k with the received sequence $\{y_1,..., y_k\}$, and the future, $\beta_k(m)$, is the probability of generating the received sequence $\{y_{k+1},..., y_N\}$ from state m at time $k$. The probability $\alpha_k(m)$ can be expressed as function of $\alpha_{k-1}(m)$ and $\gamma_k(n,m)$ and is called the forward recursion

$$\alpha_k(m) = \sum_{n=0}^{M-1} \alpha_{k-1}(n)\gamma_k(n,m) \quad m = 0,...,M-1, \qquad\qquad (2)$$

where $M$ is the number of states. The reverse or backward recursion for computing the probability $\beta_k(n)$ from $\beta_{k+1}(n)$ and $\gamma_k(n,m)$ is

$$\beta_k(n) = \sum_{m=0}^{M-1} \beta_{k+1}(m)\gamma_k(n,m) \quad n = 0,...,M-1. \qquad\qquad (3)$$

The overall *a posteriori* probabilities in equation (2) are computed by summing over the branches in the trems $B^1$ ($B^0$) that correspond to the information bii being 1 (or 0).

The LLR in equation (1) requires both the forward and reverse recursions to be available at time $k$. In general, the BCJR method for meeting this requirement is to compute and store the entire reverse recursion using a fixed number of iterations, and recursively compute $\alpha_k(m)$ and $La_k$ from $k = 1$ to $k = N$ using $\alpha_{k-1}$ and $\beta_k$.

The performance of turbo decoding is affected by many factors. One of the key factors is the number of iterations. As a turbo decoder converges after a few iterations, more iterations after convergence will not increase performance significantly. Turbo codes will converge faster under good channel conditions requiring a fewer number of iterations to obtain good performance. The number of iterations performed is directly proportional to the number of calculations needed and it will affect power consumption. Since power consumption is of great concern in the mobile and portable radio communication devices, there is an even higher emphasis on finding reliable and good iteration stopping criteria. Motivated by these reasons, the present invention provides an adaptive scheme for stopping the iteration process.

In the present invention, the number of iterations is defined as the total number of SISO decoding stages used (i.e. two iterations in one cycle). Accordingly, the iteration number counts from 0 to 2$N$-1. Each decoding stage can be either MAP or SOVA. The key factor in the decoding process is to combine the extrinsic information into a SISO block. The final hard decision on the information bits is made according to the value of the LLR after iterations are stopped. The final hard bit decision is based on the LLR polarity. If the LLR is positive, decide +1, otherwise decide -1 for the hard output.

In the present invention, the in-loop signal-to-noise ratio (intrinsic SNR) is used as the iteration stopping criterion in the turbo decoder. Since SNR improves when more bits are detected correctly per iteration, the present invention uses a detection quality indicator that observes the increase in signal energy relative to the noise as iterations go on.

FIG. 4 shows a turbo decoder with at least one additional Viterbi decoder to monitor the decoding process, in accordance with the present invention. Although one Viterbi decoder can be used, two decoders give the flexibility to stop iterations at any SISO decoder. The Viterbi decoders are used because it is easy to analyze the Viterbi decoder to get the quality index. The Viterbi decoder is just used to do the mathematics in the present invention, i.e. to derive the quality indexes and intrinsic SNR values. No real Viterbi decoding is needed. It is well known that MAP or SOVA will not outperform the conventional Viterbi decoder significantly if no iteration is applied. Therefore, the quality index also applies towards the performance of MAP and SOVA decoders. The error due to the Viterbi approximation to SISO (MAP or SOVA) will not accumulate since there is no change in the turbo decoding process itself. Note that the turbo decoding process remains as it is. The at least one additional Viterbi decoder is attached for analysis to generate the quality index and no decoding is actually needed.

In a preferred embodiment, two Viterbi decoders are used. In practice, where two identical RSC encoder are used, thus requiring identical SISO decoders, only one Viterbi decoder is needed, although two of the same decoders can be used. Otherwise, the two Viterbi decoders are different and they are both required. Both decoders generate an iteration stopping signal, and they act independently such that either decoder can signal a stop to iterations. The Viterbi decoders are not utilized in the traditional sense in that they are only used to do the mathematics and derive the quality indexes and intrinsic SNR values. In addition, since iterations can be stopped mid-cycle at any SISO decoder, a soft output is generated for the transmitted bits from the LLR of the decoder where the iteration is stopped.

The present invention utilizes the extrinsic information available in the iterative loop in the Viterbi decoder. For an AWGN channel, we have the following path metrics with the extrinsic information input:

$$p[Y \mid X] = \prod_{i=0}^{L-1} p[y_i \mid x_i] p[t_i \mid p_i] p[m_i]$$

where $m_i$ is the transmitted information bit, $x_i = m_i$ is the systematic bit, and $p_i$ is the parity bit. With $m_i$ in polarity form (1 → +1 and 0 → -1), we rewrite the extrinsic information as

$$p[m_i] = \frac{e^{z_i}}{1 + e^{z_i}} = \frac{e^{z_i/2}}{e^{-z_i/2} + e^{z_i/2}}, \quad \text{if } m_i = +1$$

$$p[m_i] = \frac{1}{1 + e^{z_i}} = \frac{e^{-z_i/2}}{e^{-z_i/2} + e^{z_i/2}}, \quad \text{if } m_i = -1$$

$p[m_i]$ is the a priori information about the transmitted bits,

$$z_i = \log \frac{p[m_i = +1]}{p[m_i = -1]}$$

is the extrinsic information, or in general,

$$p[m_i] = \frac{e^{m_i z_i/2}}{e^{-z_i/2} + e^{z_i/2}}$$

The path metric is thus calculated as

$$p[Y \mid X] = \prod_{i=0}^{L-1} p[y_i \mid x_i] p[t_i \mid p_i] p[m_i]$$

$$= (\frac{1}{\sqrt{2\pi}\sigma})^L e^{-\frac{1}{2\sigma^2}\sum_{i=0}^{L-1}\{(x_i - y_i)^2 + (p_i - t_i)^2\}} (\prod_{i=0}^{L-1} \frac{1}{e^{-z_i/2} + e^{z_i/2}}) e^{\frac{1}{2}\sum_{i=0}^{L-1} m_i z_i}$$

Note that $e^{\frac{1}{2}\sum_{i=0}^{L-1} m_i z_i}$ is the correction factor introduced by the extrinsic information. And from the Viterbi decoder point of view, this correcting factor improves the path metric and thus improves the decoding performance. This factor is the improvement brought forth by the extrinsic information. The present invention introduces this factor as the quality index and the iteration stopping criteria for turbo codes.

In particular, the turbo decoding quality index $Q(iter, \{m_i\}, L)$ is:

$$Q(iter, \{m_i\}, L) = \sum_{i=0}^{L-1} m_i z_i$$

where $iter$ is the iteration number, $L$ denote number of bits in each decoding block, $m_i$ is the transmitted information bit, and $z_i$ is the extrinsic information generated after each small decoding step. More generally,

$$Q(iter, \{m_i\}, \{w_i\}, L) = \sum_{i=0}^{L-1} w_i m_i z_i$$

where $w_i$ is a weighting function to alter performance. In a preferred embodiment, $w_i$ is a constant of 1.

This index remains positive since typically $z_i$ and $m_i$ have the same polarity. In practice, the incoming data bits $\{m_i\}$ are unknown, and the following index is used instead:

$$Q_H(iter, \{m_i\}, L) = \sum_{i=0}^{L-1} \hat{d}_i z_i$$

where $\hat{d}_i$ is the hard decision as extracted from the LLR information. That is $\hat{d}_i = sign\{L_i\}$ with $L_i$ denoting the LLR value. The following soft output version of the quality index can also be used for the same purpose:

$$Q_S(iter, \{m_i\}, L) = \sum_{i=0}^{L-1} L_i z_i$$

or more generally

$$Q_S(iter, \{m_i\}, \{w_i\}, L) = \sum_{i=0}^{L-1} w_i L_i z_i$$

Note that these indexes are extremely easy to generate and require very little hardware. In addition, these indexes have virtually the same asymptotic behavior and can be used as a good quality index for the turbo decoding performance evaluation and iteration stopping criterion.

The behavior of these indexes is that they increase very quickly for the first a few iterations and then they approach an asymptote of almost constant value. As can be seen from simulation results below, this asymptotic behavior describes the turbo decoding process well and serves as a quality monitor of the turbo decoding process. In operation, the iterations are stopped if this index value crosses the knee of the asymptote.

The iterative loop of the turbo decoder increases the magnitude of the LLR such that the decision error probability will be reduced. Another way to look at it is that the extrinsic information input to each decoder is virtually improving the SNR of the input sample streams. The following analysis is presented to show that what the extrinsic information does is to improve the virtual SNR to each constituent decoder. This helps to explain how the turbo coding gain is reached. Analysis of the incoming samples is also provided with the assistance of the Viterbi decoder as described before.

The path metric equation of the attached additional Viterbi decoders is

$$p[Y \mid X] = (\frac{1}{\sqrt{2\pi}\sigma})^L e^{-\frac{1}{2\sigma^2}\sum_{i=0}^{L-1}\{(x_i-y_i)^2+(p_i-t_i)^2\}} (\prod_{i=0}^{L-1}\frac{1}{e^{-z_i/2}+e^{z_i/2}})e^{\frac{1}{2}\sum_{i=0}^{L-1}m_i z_i}$$

Expansion of this equation gives

$$p[Y \mid X] = (\frac{1}{\sqrt{2\pi}\sigma})^{2L}(\prod_{i=0}^{L-1}\frac{1}{e^{-z_i/2}+e^{z_i/2}}) \cdot e^{-\frac{1}{2\sigma^2}\sum_{i=0}^{L-1}(x_i^2+y_i^2)} e^{-\frac{1}{2\sigma^2}\sum_{i=0}^{L-1}(t_i^2+p_i^2)} e^{\frac{1}{2\sigma^2}\sum_{i=0}^{L-1}(2x_i y_i+2t_i p_i)} e^{\frac{1}{2}\sum_{i=0}^{L-1}x_i z_i}$$

$$= (\frac{1}{\sqrt{2\pi}\sigma})^{2L}(\prod_{i=0}^{L-1}\frac{1}{e^{-z_i/2}+e^{z_i/2}}) \cdot e^{-\frac{1}{2\sigma^2}\sum_{i=0}^{L-1}(x_i^2+y_i^2)} e^{-\frac{1}{2\sigma^2}\sum_{i=0}^{L-1}(t_i^2+p_i^2)} e^{\frac{1}{\sigma^2}\sum_{i=0}^{L-1}(x_i y_i+t_i p_i)+\frac{1}{2}\sum_{i=0}^{L-1}x_i z_i}$$

Looking at the correlation term, we get the following factor

$$\frac{1}{\sigma^2}\sum_{i=0}^{L-1}(x_i y_i + \frac{\sigma^2}{2}x_i z_i) + \frac{1}{\sigma^2}\sum_{i=0}^{L-1}t_i p_i$$

$$= \frac{1}{\sigma^2}\sum_{i=0}^{L-1}x_i(y_i + \frac{\sigma^2}{2}z_i) + \frac{1}{\sigma^2}\sum_{i=0}^{L-1}t_i p_i$$

$$= \frac{1}{\sigma^2}\sum_{i=0}^{L-1}\{x_i(y_i + \frac{\sigma^2}{2}z_i) + t_i p_i\}$$

For the Viterbi decoder, to search for the minimum Euclidean distance is the same process as searching for the following maximum correlation.

$$\frac{1}{\sigma^2}\sum_{i=0}^{L-1}\{x_i(y_i + \frac{\sigma^2}{2}z_i) + t_i p_i\}$$

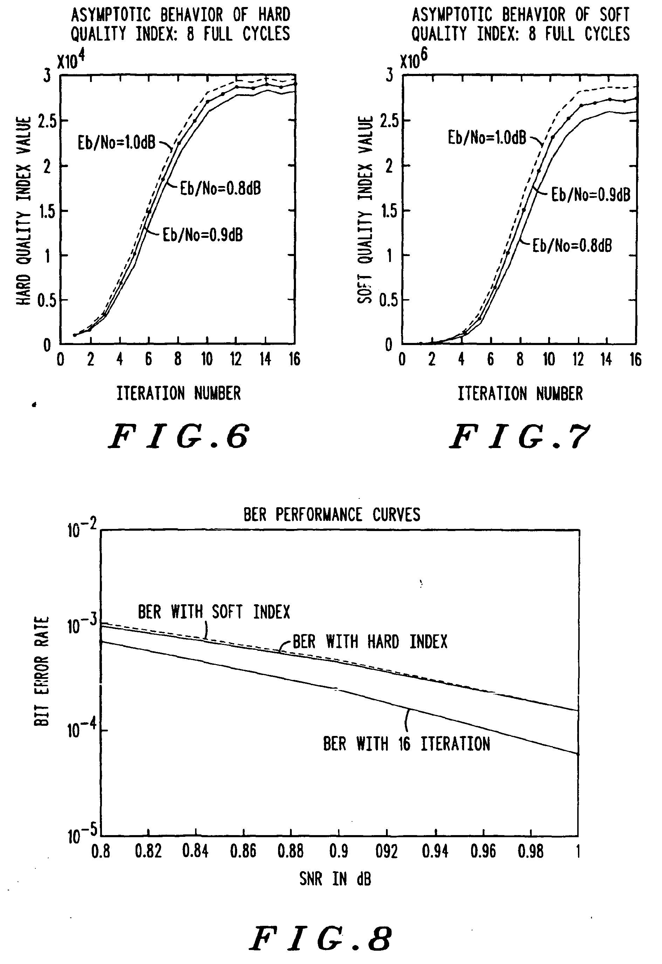

or equivalently, the input data stream to the Viterbi decoder is $\{(y_i + \frac{\sigma^2}{2}z_i), t_i)\}$, which is graphically depicted in FIG. 5.

Following the standard signal-to-noise ratio calculation formula

$$SNR = \frac{(E[y_i \mid x_i])^2}{\sigma^2}$$

and given the fact that $y_i = x_i + n_i$ and $t_i = p_i + n_i$ (where $p_i$ are the parity bits of the incoming signal), we get SNR for the input data samples into the constituent decoder as

$$SNR(x_i, y_i, iter) = \frac{(E[y_i + \frac{\sigma^2}{2} z_i \mid x_i])^2}{\sigma^2}$$

$$= \frac{(E[x_i + n_i + \frac{\sigma^2}{2} z_i \mid x_i])^2}{\sigma^2}$$

$$= \frac{(x_i + \frac{\sigma^2}{2} z_i)^2}{\sigma^2}$$

$$= \frac{x_i^2}{\sigma^2} + x_i z_i + \frac{\sigma^2}{4} z_i^2$$

Notice that the last two terms are correction terms due to the extrinsic information input. The SNR for the input parity samples are

$$SNR(p_i, t_i, iter) = \frac{(E[t_i \mid p_i])^2}{\sigma^2} = \frac{(E[p_i + n_i' \mid p_i])^2}{\sigma^2} = \frac{p_i^2}{\sigma^2}$$

Now it can be seen that the SNR for each received data samples are changing as iterations go on because the input extrinsic information will increase the virtual or intrinsic SNR. Moreover, the corresponding SNR for each parity sample will not be affected by the iteration. Clearly, if $x_i$ has the same sign as $z_i$, we have

$$SNR(x_i, y_i, iter) = \frac{(x_i + \frac{\sigma^2}{2} z_i)^2}{\sigma^2} \geq \frac{x_i^2}{\sigma^2} = SNR(x_i, y_i, iter = 0)$$

This shows that the extrinsic information increased the virtual SNR of the data stream input to each constituent decoder.

The average SNR for the whole block is

$$AverageSNR(iter) = \frac{1}{2L}\{\sum_{i=0}^{L-1} SNR(x_i, y_i, iter) + \sum_{i=0}^{L-1} SNR(p_i, t_i, iter)\}$$

$$= \frac{1}{2L}\{\sum_{i=0}^{L-1} \frac{x_i^2}{\sigma^2} + \sum_{i=0}^{L-1} \frac{p_i^2}{\sigma^2}\} + \frac{1}{2L}\{\sum_{i=0}^{L-1} x_i z_i + \frac{\sigma^2}{4} \sum_{i=0}^{L-1} z_i^2\}$$

$$= AverageSNR(0) + \frac{1}{2L} Q(iter, \{m_i\}, L) + \frac{\sigma^2}{4}(\frac{1}{2L} \sum_{i=0}^{L-1} z_i^2)$$

at each iteration stage.

If the extrinsic information has the same sign as the received data samples and if the magnitudes of the $z_i$ samples are increasing, the average SNR of the whole block will increase as the number of iteration increases. Note that the second term is the original quality index, as described previously, divided by the block size. The third term is directly proportional to the average of magnitude squared of the extrinsic information and is always positive. This intrinsic SNR expression will have the similar asymptotic behavior as the previously described quality indexes and can also be used as decoding quality indicator. Similar to the quality indexes, more practical intrinsic SNR values are:

$$AverageSNR_H(iter) = StartSNR + \frac{1}{2L}Q_H(iter, \{m_i\}, L) + \frac{\sigma^2}{4}\left(\frac{1}{2L}\sum_{i=0}^{L-1} z_i^2\right),$$

or a corresponding soft copy of it

$$AverageSNR_S(iter) = StartSNR + \frac{1}{2L}Q_S(iter, \{m_i\}, L) + \frac{\sigma^2}{4}\left(\frac{1}{2L}\sum_{i=0}^{L-1} z_i^2\right)$$

where *StartSNR* denotes the initial SNR value that starts the decoding iterations. Optionally, a weighting function can be used here as well. Only the last two terms are needed to monitor the decoding quality. Note also that the normalization constant in the previous intrinsic SNR expressions has been ignored.

In review, the present invention provides a decoder that dynamically terminates iteration calculations in the decoding of a received convolutionally coded signal using quality index criteria. The decoder includes a standard turbo decoder with two recursion processors connected in an iterative loop. A novel aspect of the inventions is having at least one additional recursion processor coupled in parallel at the inputs of at least one of the recursion processors. Preferably, the at least one additional recursion processor is a Viterbi decoder, and the two recursion processors are soft-input, soft-output decoders. More preferably, there are two additional processors coupled in parallel at the inputs of the two recursion processors, respectively. All of the recursion processors, including the additional processors, perform concurrent iterative calculations on the signal. The at least one additional recursion processor calculates a quality index of the signal for each iteration and directs a controller to terminates the iterations when the measure of the quality index exceeds a predetermined level.

The quality index is a summation of generated extrinsic information multiplied by a quantity extracted from the LLR information at each iteration. The quantity can be a hard decision of the LLR value or the LLR value itself. Alternatively, the quality index is an intrinsic signal-to-noise ratio of the signal calculated at each iteration. In particular, the intrinsic signal-to-noise ratio is a function of the quality index added to a summation of the square of the generated extrinsic information at each iteration. The intrinsic signal-to-noise ratio can be calculated using the quality index with the quantity being a hard decision of the LLR value, or the intrinsic signal-to-noise ratio is calculated using the quality index with the quantity being the LLR value. In practice, the measure of the quality index is a slope of the quality index taken over consecutive iterations.

The key advantages of the present invention are easy hardware implementation and flexibility of use. In other words, the present invention can be used to stop iteration at any SISO decoder, or the iteration can be stopped at half cycles. In addition, SNR is derived according to Viterbi decoding which does not use a square root operation which would require much increased circuit complexity or the use of an approximation. In contrast, the present invention has a very simple hardware implementation.

FIG. 6 shows simulation results using the turbo decoding in accordance with the present invention. The performance of $Q_H(iter, \{m_i\}, L)$ and $Q_s(iter, \{m_i\}, L)$ were verified through numerical simulations. The simulation results are presented to demonstrate the asymptotic behavior of these indexes. Then the performance of the turbo decoder is shown given that the hard and soft indexes are being used as an iteration stopping criteria. The code used is the CDMA2000 standard code with code rate 1/3, G1=13 and G2=15, as recognized in the art. The simulation was run with 2000 frames of size 640 bits and the SNR points are 0.8dB, 0.9dB and 1.0 dB. Viterbi's memory cutting technique, known in the art for more realistic results, is implemented with synchronization learning length 30. The asymptotic behavior of the hard quality index $Q_H(iter, \{m_i\}, L)$ and the soft quality index $Q_S(iter, \{m_i\}, L)$ is depicted in FIGs. 6 and 7.

FIGs. 6 and 7 shows that the slope of the asymptotic curves increases as the SNR gets higher. This is as expected since high SNR gives better extrinsic information in decoding. As can be seen, the quality indexes reach their asymptotes faster as SNR increases which means less iterations are needed for convergence. This can be seen through Viterbi decoder analysis.

Based on the asymptotic behavior of the quality indexes, the decoding iterations are stopped by checking the percentage of increase (i.e. the curve slope or derivative) of these indexes. The stopping criteria used in the following plots are based on the curve slope with threshold 0.03 dB. That is if

$$\{Q_H(iter+1,\{m_i\},L)-Q_H(iter,\{m_i\},L)\}/Q_H(iter,\{m_i\},L) < 0.03 \text{ dB}$$

the iterations can be stopped. Similarly, for the son quality index, the same threshold of 0.03 dB can be used. That is if

$$\{Q_S(iter+1,\{m_i\},L)-Q_S(iter,\{m_i\},L)\}/Q_S(iter,\{m_i\},L) < 0.03 \text{ dB}$$

the iterations are stopped. In addition, iterations can be stopped once these indexes pass a predetermined threshold to avoid any false indications. Alternately, a certain number of mandatory iterations can be imposed before the indexes are used as criteria for iteration stopping.

The BER performance curves based on the direct use of the hard and soft quality indexes are presented in FIG. 8. In this preferred case, a mandatory minimum number of nine iterations (that is 4.5 full cycles) are used followed by application of the quality indexes. The indexes were applied with an increment threshold 0.03 dB. The maximum number of iterations used in both cases was sixteen. The minimum number of iterations used in both cases was nine. Table 1 lists the average number of iterations to show the computation savings.

Table 1

| SNR | Average number of iteration with the hard quality index | Average number of iteration with the soft quality index |
|---|---|---|
| 0.8 dB | 12.2910 | 13.2020 |
| 0.9 dB | 11.8265 | 12.7995 |
| 1.0 dB | 11.4195 | 12.3955 |

As expected, the number of average iterations needed decreases as SNR increases. In addition, the degradation of signal integrity due to iteration stopping is much less than 0.1 dB.

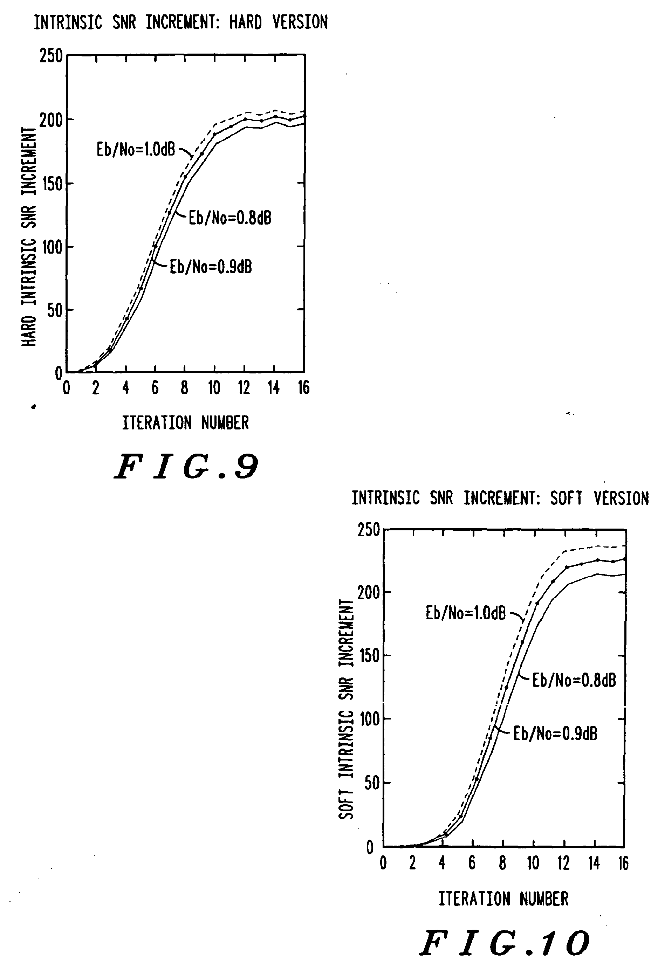

In the present invention, intrinsic SNR can also be used as an iteration stopping criteria. Due to the close relationship between intrinsic SNR and the quality indexes, the numerical results with the hard and soft intrinsic SNR has similar performance, as shown in FIGs. 9 and 10. Only the asymptotic behavior of the sum of the last two terms in the intrinsic SNR expression are shown.

Optionally, the quality indexes and intrinsic SNR can be used as a retransmit criteria in an ARQ system. For example, using a lower threshold for frame quality, if the quality indexes or intrinsic SNR are still below the lower threshold after a predetermined number of iterations, decoding can be stopped and a request sent for frame retransmission.

As should be recognized, the hardware needed to implement quality indexes for iteration stopping is extremely simple. Since there are LLR and extrinsic information output in each constituent decoding stage, only a MAC (multiply and accumulate unit) is needed to calculate the soft index. Also, only one memory unit is needed to store the index and to compare it with the next one for slope calculation. Moreover, all the quality index values at different iteration stages can be stored with very few memory elements. A comparison unit based on one subtraction and one division is needed. For the hard index, a slicer is needed for hard decision before the MAC. Advantageously, these indexes can be implemented with some simple attachment to the current design.

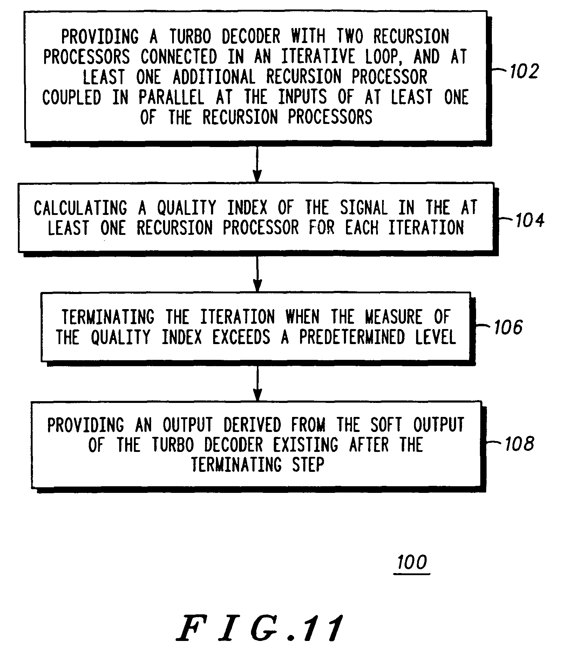

FIG. 11 shows a flow chart representing a method 100 of terminating iteration calculations in the decoding of a received convolutionally coded signal using quality index criteria, in accordance with the present invention. A first step 102 is providing a turbo decoder with two recursion processors connected in an iterative loop, and at least one additional recursion processor coupled in parallel at the inputs of at least one of the recursion processors. All of the recursion processors concurrently performing iteration calculations on the signal. In a preferred embodiment, the at least one additional recursion processor is a Viterbi decoder, and the two recursion processors are soft-input, soft-output decoders. More preferably, two additional processors are coupled in parallel at the inputs of the two recursion processors, respectively.

A next step 104 is calculating a quality index of the signal in the at least one recursion processor for each iteration. In particular, the quality index is a summation of generated extrinsic information from the recursion processors multiplied by a quantity extracted from the LLR information of the recursion processors at each iteration. The quality index can be a hard value of a soft value. For the hard value, the quantity is a hard decision of the LLR value. For the soft value, the quantity is the LLR value itself. Optionally, the quality index is an intrinsic signal-to-noise ratio (SNR) of the signed calculated at each iteration. The intrinsic SNR is a function of an initial signal-to-noise ratio added to the quality index added to a summation of the square of the generated extrinsic information at each iteration. However, only the last two terms are useful for the quality index criteria. For this case, there are also hard and soft values for the intrinsic SNR, using the corresponding hard and soft decisions of the quality index just described.

A next step 106 is terminating the iterations when the measure of the quality index exceeds a predetermined level. Preferably, the terminating step includes the measure of the quality index being a slope of the quality index over the iterations. In practice, the predetermined level is at a knee of the quality index curve approaching its asymptote. More specifically, the predetermined level is set at 0.03 dB of SNR. A next step 108 is providing an output derived from the soft output of the turbo decoder existing after the terminating step.

While specific components and functions of the turbo decoder for convolutional codes are described above, fewer or additional functions could be employed by one skilled in the art and be within the broad scope of the present invention. The invention should be limited only by the appended claims.

**Claims**

1. A method (100) of terminating iteration calculations in the decoding of a received convolutionally coded signal using quality index criteria, the method comprising the steps of:

   providing (102) a turbo decoder with two recursion processors connected in an iterative loop, the two decoders iteratively decoding the received signal, and at least one Viterbi recursion processor coupled in parallel at the inputs of at least one of the recursion processors, all of the recursion processors concurrently performing iteration calculations on the signal;
   calculating (104) a quality index of the signal in the at least one Viterbi recursion processor for each iteration;
   terminating (106) the iterations when the measure of the quality index exceeds a predetermined level; and
   providing (108) an output derived from the soft output of the turbo decoder existing after the terminating step.

2. The method of claim 1, wherein the two recursion processors are soft-input, soft-output decoders.

3. The method of claim 1, wherein the first providing step includes two additional processors being coupled in parallel at the inputs of the two recursion processors, respectively.

4. The method of claim 1, wherein the calculating step includes the quality index being a summation of generated extrinsic information multiplied by a quantity extracted from the LLR information at each iteration.

5. The method of claim 4, wherein the calculating step includes the quantity being a hard decision of the LLR value.

6. The method of claim 4, wherein the calculating step includes the quantity being the LLR value.

7. The method of claim 4, wherein the calculating step includes the quality index being an intrinsic signal-to-noise ratio of the signal calculated at each iteration, the intrinsic signal-to-noise ratio being a function of the quality index added to a summation of the square of the generated extrinsic information at each iteration.

8. The method of claim 7, wherein the calculating step includes the intrinsic signal-to-noise ratio being calculated using the quality index with the quantity being a hard decision of the LLR value.

9. The method of claim 7, wherein the calculating step includes the intrinsic signal-to-noise ratio being calculated using the quality index with the quantity being the LLR value.

10. The method of claim 1, wherein the terminating step includes the measure of the quality index being a slope of the quality index over the iterations.

11. A decoder adapted to implement the method according to any one of claims 1-10.

**Patentansprüche**

1. Verfahren (100) zum Beenden von Iterationsberechnungen bei der Decodierung eines empfangenen faltungscodierten Signals unter Verwendung von Qualitätsindexkriterien, wobei das Verfahren die folgenden Schritte aufweist:

Bereitstellen (102) eines Turbodecoders mit zwei in einer Iterationsschleife angeschlossenen Rekursionsprozessoren, wobei die beiden Decoder das empfangene Signal iterativ decodieren, und mit mindestens einem Viterbi-Rekursionsprozessor, welcher mit den Eingängen zumindest eines der Rekursionsprozessoren parallel geschaltet ist, wobei alle Rekursionsprozessoren gleichzeitig Iterationsberechnungen an dem Signal durchführen;

Berechnen (104) eines Qualitätsindex des Signals in dem mindestens einen Viterbi Rekursionsprozessor für jede Iteration;

Beenden (106) der Iterationen, wenn der Faktor des Qualitätsindex einen vorbestimmten Pegel überschreitet; und

Liefern (108) eines Ausgangssignals, das vom Soft-Output des Turbodecoders erhalten wird, welches nach dem Beendigungsschritt vorliegt.

2. Verfahren nach Anspruch 1, **dadurch gekennzeichnet, dass** die beiden Rekursionsprozessoren Soft-Input- und Soft-Output-Decoder sind.

3. Verfahren nach Anspruch 1, **dadurch gekennzeichnet, dass** der erste Bereitstellungsschritt zwei zusätzliche Prozessoren einschließt, die jeweils an den Eingängen der beiden Rekursionsprozessoren parallel geschaltet sind.

4. Verfahren nach Anspruch 1, **dadurch gekennzeichnet, dass** der Berechnungsschritt den Qualitätsindex einschließt, welcher eine Summierung erzeugter nicht zugehöriger Information multipliziert mit einer Größe ist, die aus der LLR-Information bei jeder Iteration extrahiert wird.

5. Verfahren nach Anspruch 4, **dadurch gekennzeichnet, dass** der Berechnungsschritt die Größe einschließt, welche eine harte Entscheidung oder Hard Decision des LLR-Werts ist.

6. Verfahren nach Anspruch 4, **dadurch gekennzeichnet, dass** der Berechnungsschritt die Größe einschließt, welche der LLR-Wert ist.

7. Verfahren nach Anspruch 4, **dadurch gekennzeichnet, dass** der Berechnungsschritt den Qualitätsindex einschließt, welcher ein unbezogener oder freier Störabstand des bei jeder Iteration berechneten Signals ist, wobei der unbezogene Störabstand eine Funktion des Qualitätsindex ist, der einer Summierung des Quadrats der erzeugten nicht zugehörigen Informationen bei jeder Iteration ist.

8. Verfahren nach Anspruch 7, **dadurch gekennzeichnet, dass** der Berechnungsschritt einschließt, dass der unbezogene oder freie Störabstand unter Verwendung des Qualitätsindex mit der Größe, welche eine harte Entscheidung des LLR-Werts ist, berechnet wird.

9. Verfahren nach Anspruch 7, **dadurch gekennzeichnet, dass** der Berechnungsschritt einschließt, dass der unbezogene oder freie Störabstand unter Verwendung des Qualitätsindex mit der Größe, welche der LLR-Wert ist, berechnet wird.

10. Verfahren nach Anspruch 1, **dadurch gekennzeichnet, dass** der Beendigungsschritt einschließt, dass der Faktor des Qualitätsindex eine Abstufung des Qualitätsindex über die Iterationen ist.

11. Decoder, der zur Implementierung des Verfahrens nach einem der Ansprüche 1 bis 10 ausgelegt ist.

**Revendications**

1. Procédé (100) pour terminer des calculs d'itération dans le décodage d'un signal reçu codé par convolution en utilisant des critères d'indice de qualité, le procédé comprenant les étapes consistant à:

munir (102) un décodeur turbo de deux processeurs de récurrence connectés dans une boucle itérative, les deux décodeurs décodant de manière itérative le signal reçu, et d'au moins un processeur de récurrence Viterbi couplé en parallèle aux entrées d'au moins un des processeurs de récurrence, tous les processeurs de récurrence effectuant simultanément des calculs d'itération sur le signal;

calculer (104) un indice de qualité du signal dans le au moins un processeur de récurrence Viterbi pour chaque itération;

terminer (106) les itérations lorsque la mesure de l'indice de qualité dépasse un niveau prédéterminé; et

délivrer (108) une sortie dérivée de la sortie souple du décodeur turbo existant après l'étape d'achèvement.

2. Procédé selon la revendication 1, dans lequel les deux processeurs de récurrence sont des décodeurs à entrées souples et à sorties souples.

3. Procédé selon la revendication 1, dans lequel la première étape consistant à munir le décodeur comprend deux processeurs supplémentaires étant respectivement couplés en parallèle aux entrées des deux processeurs de récurrence.

4. Procédé selon la revendication 1, dans lequel l'étape de calcul comprend l'indice de qualité étant une sommation d'informations extrinsèques générées multipliées par une quantité extraite des informations LLR à chaque itération.

5. Procédé selon la revendication 4, dans lequel l'étape de calcul comprend la quantité étant une décision ferme de la valeur LLR.

6. Procédé selon la revendication 4, dans lequel l'étape de calcul comprend la quantité étant la valeur LLR.

7. Procédé selon la revendication 4, dans lequel l'étape de calcul comprend l'indice de qualité étant un rapport signal sur bruit intrinsèque du signal calculé à chaque itération, le rapport signal sur bruit intrinsèque étant une fonction de l'indice de qualité ajouté à une sommation du carré de l'information extrinsèque générée à chaque itération.

8. Procédé selon la revendication 7, dans lequel l'étape de calcul comprend le rapport signal sur bruit intrinsèque étant calculé en utilisant l'indice de qualité avec la quantité étant une décision ferme de la valeur LLR.

9. Procédé selon la revendication 7, dans lequel l'étape de calcul comprend le rapport signal sur bruit intrinsèque étant calculé en utilisant l'indice de qualité avec la quantité étant la valeur LLR.

10. Procédé selon la revendication 1, dans lequel l'étape d'achèvement comprend la mesure de l'indice de qualité étant une pente de l'indice de qualité à mesure des itérations.

11. Décodeur adapté pour implémenter le procédé selon l'une quelconque des revendications 1 à 10.

*F I G . 1*

*F I G . 2*

*F I G . 3*

*F I G . 4*

*F I G . 5*

ASYMPTOTIC BEHAVIOR OF HARD
QUALITY INDEX: 8 FULL CYCLES

*F I G . 6*

ASYMPTOTIC BEHAVIOR OF SOFT
QUALITY INDEX: 8 FULL CYCLES

*F I G . 7*

BER PERFORMANCE CURVES

*F I G . 8*

INTRINSIC SNR INCREMENT: HARD VERSION

*F I G . 9*

INTRINSIC SNR INCREMENT: SOFT VERSION

*F I G . 1 0*

PROVIDING A TURBO DECODER WITH TWO RECURSION
PROCESSORS CONNECTED IN AN ITERATIVE LOOP, AND AT
LEAST ONE ADDITIONAL RECURSION PROCESSOR
COUPLED IN PARALLEL AT THE INPUTS OF AT LEAST ONE
OF THE RECURSION PROCESSORS — 102

CALCULATING A QUALITY INDEX OF THE SIGNAL IN THE AT
LEAST ONE RECURSION PROCESSOR FOR EACH ITERATION — 104

TERMINATING THE ITERATION WHEN THE MEASURE OF
THE QUALITY INDEX EXCEEDS A PREDETERMINED LEVEL — 106

PROVIDING AN OUTPUT DERIVED FROM THE SOFT OUTPUT
OF THE TURBO DECODER EXISTING AFTER THE
TERMINATING STEP — 108

100

# F I G .11